# EUROPEAN PATENT APPLICATION

(11) **EP 4 580 348 A1**
(43) Date of publication of application: **02.07.2025**
(21) Application number: 24223481.3
(22) Date of filing: 27.12.2024
(51) Int. Cl.: H10D 89/60

(54) **CIRCUIT PROTECTION DEVICE**

(30) Priority: 27.12.2023 US 202363614957 P; 24.12.2024 US 202419001114
(71) Applicant: MediaTek Inc., Hsinchu City, 30078 (TW)
(72) Inventor: WEN, Yung-Ju, 30078 Hsinchu City (TW); HUANG, Bo-Shih, 30078 Hsinchu City (TW)
(74) Representative: Haseltine Lake Kempner LLP

(57) **Abstract**

A circuit protection device includes a control circuit, a first N-type transistor, and a first P-type transistor. The first N-type transistor includes a first terminal, a first gate terminal, and a second terminal. The first terminal is configured to receive a first voltage. The first gate terminal is coupled to the control circuit. The first P-type transistor includes a third terminal, a second gate terminal, and a fourth terminal. The third terminal is connected to the second terminal of the first N-type transistor. The second gate terminal is connected to the control circuit.

## Description

### CROSS REFERENCE TO RELATED APPLICATIONS

This Application claims priority of US Patent Application No. 63/614,957, filed on December 27, 2024, the entirety of which is incorporated by reference herein.

### BACKGROUND OF THE INVENTION

### Field of the Invention

The present invention relates to a protection device, and, in particular, to a circuit protection device.

### Description of the Related Art

Currently, an electrostatic discharge clamp is used to protect circuits from electrostatic discharge damage. In general, N normal electrostatic discharge clamps may be needed to correspond to N VDDs. As a result, circuit space is occupied and unnecessary hardware costs are incurred. However, when a number of the electrostatic discharge clamp increases, it often results in increased costs or occupied space.

### BRIEF SUMMARY OF THE INVENTION

An embodiment of the present invention provides a circuit protection device. The circuit protection device includes a control circuit, a first N-type transistor, and a first P-type transistor. The first N-type transistor includes a first terminal, a first gate terminal, and a second terminal. The first terminal is configured to receive a first voltage. The first gate terminal is coupled to the control circuit. The first P-type transistor includes a third terminal, a second gate terminal, and a fourth terminal. The third terminal is connected to the second terminal of the first N-type transistor. The second gate terminal is connected to the control circuit. The fourth terminal is configured to receive a second voltage. A first voltage value of the first voltage is greater than a second voltage value of the second voltage.

In one embodiment, the circuit protection device further includes a stacked device electrostatic discharge clamp. The control circuit further includes a first sub-terminal and a second sub-terminal. The first sub-terminal is configured to receive the first voltage, the first sub-terminal of the control circuit is coupled to the first terminal of the first N-type transistor.

In one embodiment, The second sub-terminal is configured to receive the second voltage, the second sub-terminal is coupled to the fourth terminal of the first P-type transistor.

In one embodiment, the circuit protection device further includes a second P-type transistor. The second P-type transistor includes a fifth terminal, a third gate terminal, and a sixth terminal. The fifth terminal is connected to the fourth terminal of the first P-type transistor. The third gate terminal is connected to the control circuit.

In one embodiment, the sixth terminal of the second P-type transistor is configured to receive the second voltage. The second sub-terminal is configured to receive the second voltage, the second sub-terminal is coupled to the sixth terminal of the second P-type transistor.

In one embodiment, the circuit protection device further includes a third P-type transistor. The third P-type transistor includes a seventh terminal, a fourth gate terminal, and an eighth terminal. The seventh terminal is connected to the sixth terminal of the second P-type transistor. The fourth gate terminal is connected to the control circuit.

In one embodiment, the eighth terminal of the third P-type transistor is configured to receive the second voltage. The second sub-terminal is configured to receive the second voltage, the second sub-terminal is coupled to the eighth terminal of the third P-type transistor.

In one embodiment, the circuit protection device further includes a second N-type transistor. The second N-type transistor includes a seventh terminal, a fourth gate terminal, and an eighth terminal. The seventh terminal is connected to the sixth terminal of the second P-type transistor. The fourth gate terminal is connected to the control circuit.

In one embodiment, the eighth terminal of the second N-type transistor is configured to receive the second voltage. The second sub-terminal is configured to receive the second voltage, the second sub-terminal is coupled to the eighth terminal of the second N-type transistor.

In one embodiment, the circuit protection device further includes a second N-type transistor. The second N-type transistor includes a fifth terminal, a third gate terminal, and a sixth terminal. The fifth terminal is connected to the fourth terminal of the first P-type transistor. The third gate terminal is connected to the control circuit.

In one embodiment, the sixth terminal of the second N-type transistor is configured to receive the second voltage. The second sub-terminal is configured to receive the second voltage, the second sub-terminal is coupled to the sixth terminal of the second N-type transistor.

In one embodiment, the circuit protection device further includes a second P-type transistor. The second P-type transistor includes a seventh terminal, a fourth gate terminal, and an eighth terminal. The seventh terminal is connected to the sixth terminal of the second N-type transistor. The fourth gate terminal is connected to the control circuit.

In one embodiment, the eighth terminal of the second P-type transistor is configured to receive the second voltage. The second sub-terminal is configured to receive the second voltage, the second sub-terminal is coupled to the eighth terminal of the second P-type transistor.

In one embodiment, the first terminal of the first N-type transistor is connected to the first gate terminal of the first N-type transistor.

In one embodiment, the first terminal of the first N-type transistor is connected to the control circuit.

In one embodiment, the second gate terminal of the first P-type transistor is connected to the fourth terminal of the first P-type transistor.

In one embodiment, the first N-type transistor further includes one of an N-channel Metal-Oxide-Semiconductor (NMOS) transistor and an NPN bipolar junction transistor (BJT). The first P-type transistor further includes one of a P-channel Metal-Oxide-Semiconductor (PMOS) transistor and a PNP bipolar junction transistor.

In one embodiment, the first N-type transistor further includes one of an N-channel Metal-Oxide-Semiconductor transistor and an NPN bipolar junction transistor. The first P-type transistor further includes one of a P-channel Metal-Oxide-Semiconductor transistor and a PNP bipolar junction transistor. The second P-type transistor further includes one of the P-channel Metal-Oxide-Semiconductor transistor and the PNP bipolar junction transistor.

In one embodiment, the first N-type transistor further includes one of a N-channel Metal-Oxide-Semiconductor transistor and an NPN bipolar junction transistor. The first P-type transistor further includes one of a P-channel Metal-Oxide-Semiconductor transistor and a PNP bipolar junction transistor. The second N-type transistor further includes one of an N-channel Metal-Oxide-Semiconductor transistor and an NPN bipolar junction transistor.

Therefore, according to the technical content of the present disclosure, the circuit protection device shown in the embodiment of the present disclosure can achieve the effect of using one VDD replacing multiple VDDs by using the stacked device electrostatic discharge clamp.

Other features and aspects of the present disclosure will become apparent from the following detailed description of exemplary embodiments with reference to the accompanying drawings.

### BRIEF DESCRIPTION OF THE DRAWINGS

The present invention can be more fully understood by reading the subsequent detailed description and examples with references made to the accompanying drawings, wherein:
Figure 1 is a block diagram of a circuit protection device according to one embodiment of the present disclosure.
Figure 2A is a block diagram of a circuit protection device according to one embodiment of the present disclosure.
Figure 2B is a block diagram of a circuit protection device according to one embodiment of the present disclosure.
Figure 2C is a block diagram of a circuit protection device according to one embodiment of the present disclosure.
Figure 3A is a block diagram of a circuit protection device according to one embodiment of the present disclosure.
Figure 3B is a block diagram of a circuit protection device according to one embodiment of the present disclosure.
Figure 3C is a block diagram of a circuit protection device according to one embodiment of the present disclosure.
Figure 4 is a detailed circuit diagram of a circuit protection device according to one embodiment of the present disclosure.
Figure 5 is a detailed circuit diagram of a circuit protection device according to one embodiment of the present disclosure.
Figure 6 is a detailed circuit diagram of a circuit protection device according to one embodiment of the present disclosure.
Figure 7 is a detailed circuit diagram of a circuit protection device according to one embodiment of the present disclosure.
Figure 8A is a block diagram of a circuit protection device according to one embodiment of the present disclosure.
Figure 8B is a block diagram of a circuit protection device according to one embodiment of the present disclosure.
Figure 8C is a block diagram of a circuit protection device according to one embodiment of the present disclosure.
Figure 9 is a detailed circuit diagram of a circuit protection device according to one embodiment of the present disclosure.
Figure 10 is a detailed circuit diagram of a circuit protection device according to one embodiment of the present disclosure.
Figure 11 is a detailed circuit diagram of a circuit protection device according to one embodiment of the present disclosure.
Figure 12 is a detailed circuit diagram of a circuit protection device according to one embodiment of the present disclosure.

### DETAILED DESCRIPTION OF THE INVENTION

The following description is made for the purpose of illustrating the general principles of the invention and should not be taken in a limiting sense. The scope of the invention is best determined by reference to the appended claims.

Various exemplary embodiments, features, and aspects of the present disclosure will be described in detail below with reference to the accompanying drawings. The same reference numbers in the drawings identify functionally identical or similar elements. Although various aspects of the embodiments are illustrated in the drawings, the drawings are not necessarily drawn to scale unless otherwise specified.

The word "exemplary" as used herein means "serving as an example, example, or illustrative." Any embodiment described herein as "exemplary" is not necessarily to be construed as superior or superior to other embodiments.

In addition, in order to better explain the present disclosure, numerous specific details are provided in the following specific embodiments. It will be understood by those skilled in the art that the present disclosure may be practiced without certain specific details. In some instances, methods, means, components and circuits that are well known to those skilled in the art are not described in detail in order to highlight the gist of the disclosure.

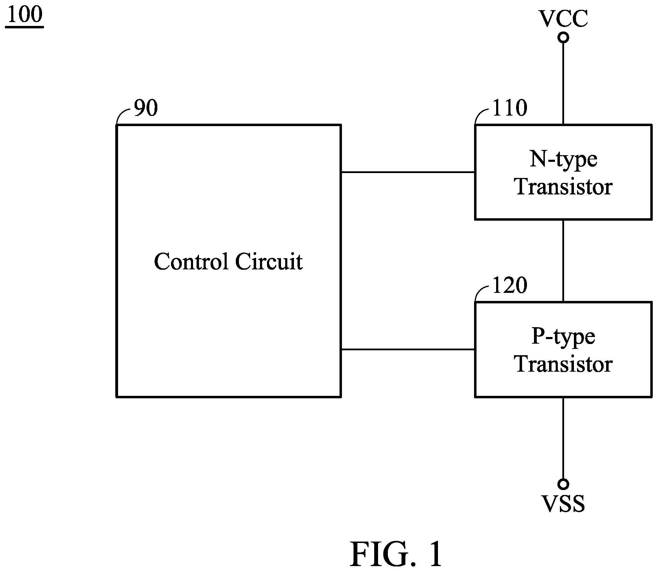

Figure 1 is a block diagram of a circuit protection device according to one embodiment of the present disclosure. As shown in Figure 1, in one embodiment, the circuit protection device 100 includes a control circuit 90, a first N-type transistor 110, and a first P-type transistor 120. The first N-type transistor 110 includes a first terminal, a first gate terminal, and a second terminal. The first terminal is configured to receive a first voltage VCC. The first gate terminal is coupled to the control circuit 90. The first P-type transistor 120 includes a third terminal, a second gate terminal, and a fourth terminal. The third terminal is connected to the second terminal of the first N-type transistor 110. The second gate terminal is connected to the control circuit 90. The fourth terminal is configured to receive a second voltage VSS.

For example, the first voltage VCC may be a circuit supply voltage, the first voltage may be 5 volt (V), but the present disclosure is not limited thereto. In some embodiments, the fourth terminal of the first P-type transistor may be coupled to the ground terminal, the circuit protection device 100 may conduct the static electricity or the excess charge into the ground terminal to protect the circuit (such as the circuit protection device 100, or the circuit coupled to the circuit protection device 100), but the present disclosure is not limited thereto.

In some embodiments, a first voltage value of the first voltage VCC may be greater than a second voltage value of the second voltage VSS, the first voltage value of the first voltage VCC may be 5V, and the second voltage value of the second voltage VSS may be 0V (that is, the ground terminal) or -5V, but the present disclosure is not limited thereto.

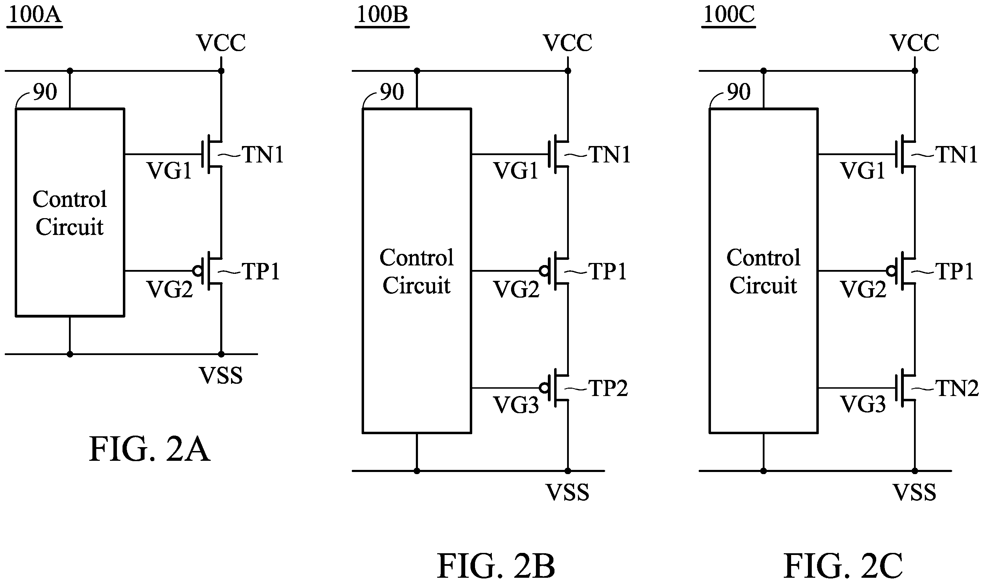

Figure 2A is a block diagram of a circuit protection device according to one embodiment of the present disclosure. As shown in Figure 2A, in one embodiment, the circuit protection device 100A includes the control circuit 90, the first N-type transistor TN1, and the first P-type transistor TP1. For example, the control circuit 90, the first N-type transistor TN1, and the first P-type transistor TP1 in Figure 2A may correspond to the control circuit 90, the first N-type transistor 110, and the first P-type transistor 120 in Figure 1, but the present disclosure is not limited thereto.

In some embodiments, the first terminal of the first N-type transistor TN1 may receive the signal VCC, the first gate terminal of the first N-type transistor TN1 may receive the signal VG1, and the second terminal of the first N-type transistor TN1 may receive the signal VSS through the first P-type transistor TP1. The third terminal of the first P-type transistor TP1 may receive the signal VCC through the first N-type transistor TN1, the second gate terminal of the first P-type transistor TP1 may receive the signal VG2, and the fourth terminal of the first P-type transistor TP1 may receive the signal VSS. The control circuit 90 may receive the signal VCC and the signal VSS, the control circuit 90 may output the signal VG1 and the signal VG2, but the present disclosure is not limited thereto.

In one embodiment, the circuit protection device 100A further includes a stacked device electrostatic discharge clamp. For example, the circuit protection device 100A may be the stacked device electrostatic discharge (ESD) clamp, the circuit protection device 100A may be used in ESD circuit field, but the present disclosure is not limited thereto.

In one embodiment, the control circuit 90 further includes a first sub-terminal and a second sub-terminal. The first sub-terminal is configured to receive the first voltage VCC, the first sub-terminal of the control circuit 90 is coupled to the first terminal of the first N-type transistor TN1.

For example, the first sub-terminal of the control circuit 90 may connect to the first terminal of the first N-type transistor TN1, the control circuit 90 may connect to the first gate terminal of the first N-type transistor TN1, but the present disclosure is not limited thereto.

In one embodiment, the second sub-terminal is configured to receive the second voltage VSS, the second sub-terminal is coupled to the fourth terminal of the first P-type transistor TP1.

For example, the second sub-terminal of the control circuit 90 may connect to the fourth terminal of the first P-type transistor TP1, the control circuit 90 may connect to the second gate terminal of the first P-type transistor TP 1, but the present disclosure is not limited thereto.

In some embodiments, the first N-type transistor TN1 is turned on (or turned off) and then the first P-type transistor TP1 is turned on (or turned off), but the present disclosure is not limited thereto. In some embodiments, the first N-type transistor TN1 and the first P-type transistor TP1 are turned on (or turned off) at the same time, but the present disclosure is not limited thereto. In some embodiments, the first P-type transistor TP1 is turned on (or turned off) and then the first N-type transistor TN1 is turned on (or turned off), but the present disclosure is not limited thereto.

In one embodiment, the first N-type transistor TN1 further includes one of an N-channel Metal-Oxide-Semiconductor (NMOS) transistor (such as an N-channel Metal-Oxide-Semiconductor Field-Effect) and an NPN bipolar junction transistor (BJT). The first P-type transistor TP1 further includes one of a P-channel Metal-Oxide-Semiconductor (PMOS) transistor (such as a P-channel Metal-Oxide-Semiconductor Field-Effect) and a PNP BJT.

Figure 2B is a block diagram of a circuit protection device according to one embodiment of the present disclosure. As shown in Figure 2B, in one embodiment, a part of the circuit protection device 100B in Figure 2B may correspond to a part of the circuit protection device 100A in Figure 2A. What needs special explanation is that the circuit protection device 100B further includes a second P-type transistor TP2. The second P-type transistor TP2 includes a fifth terminal, a third gate terminal, and a sixth terminal. The fifth terminal is connected to the fourth terminal of the first P-type transistor TP1. The third gate terminal is connected to the control circuit 90.

For example, the fifth terminal of the second P-type transistor TP2 may receive the signal VCC through the first N-type transistor TN1 and the first P-type transistor TP1, the third gate terminal of the second P-type transistor TP2 may receive the signal VG3, and the sixth terminal of the second P-type transistor TP2 may receive the signal VSS, but the present disclosure is not limited thereto.

In one embodiment, the sixth terminal of the second P-type transistor TP2 is configured to receive the second voltage VSS. The second sub-terminal is configured to receive the second voltage VSS, the second sub-terminal is coupled to the sixth terminal of the second P-type transistor TP2. For example, the second sub-terminal of the control circuit 90 may connect to the sixth terminal of the second P-type transistor TP2, but the present disclosure is not limited thereto.

In some embodiments, the first N-type transistor TN1, the first P-type transistor TP1, and the second P-type transistor TP2 are turned on (or turned off) in sequence, but the present disclosure is not limited thereto. In some embodiments, the first N-type transistor TN1, the first P-type transistor TP1, and the second P-type transistor TP2 are turned on (or turned off) at the same time, but the present disclosure is not limited thereto. In some embodiments, the second P-type transistor TP2, the first P-type transistor TP1, and the first N-type transistor TN1 are turned on (or turned off) in sequence, but the present disclosure is not limited thereto.

In one embodiment, the first N-type transistor TN1 further includes one of the NMOS transistor and the NPN BJT. The first P-type transistor TP1 further includes one of the PMOS transistor and the PNP BJT. The second P-type transistor TP2 further includes one of the PMOS transistor and the PNP BJT.

Figure 2C is a block diagram of a circuit protection device according to one embodiment of the present disclosure. As shown in Figure 2C, in one embodiment, a part of the circuit protection device 100C in Figure 2C may correspond to a part of the circuit protection device 100A in Figure 2A. What needs special explanation is that the circuit protection device 100C further includes a second N-type transistor TN2. The second N-type transistor TN2 includes a fifth terminal, a third gate terminal, and a sixth terminal. The fifth terminal is connected to the fourth terminal of the first P-type transistor TP1. The third gate terminal is connected to the control circuit 90.

For example, the fifth terminal of the second N-type transistor TN2 may receive (or couple to) the signal VCC, the third gate terminal of the second N-type transistor TN2 may receive the signal VG3, and the sixth terminal of the second N-type transistor TN2 may receive (or couple to) the signal VSS, but the present disclosure is not limited thereto.

In one embodiment, the sixth terminal of the second N-type transistor TN2 is configured to receive the second voltage VSS. The second sub-terminal is configured to receive the second voltage VSS, the second sub-terminal is coupled to the sixth terminal of the second N-type transistor TN2. For example, the second sub-terminal of the control circuit 90 may connect to the sixth terminal of the second P-type transistor TP2, but the present disclosure is not limited thereto.

In some embodiments, the first N-type transistor, the first P-type transistor, and the second N-type transistor are turned on (or turned off) in sequence, but the present disclosure is not limited thereto. In some embodiments, the first N-type transistor, the first P-type transistor, and the second N-type transistor are turned on (or turned off) at the same time, but the present disclosure is not limited thereto. In some embodiments, the second N-type transistor, the first P-type transistor, and the first N-type transistor are turned on (or turned off) in sequence, but the present disclosure is not limited thereto.

In one embodiment, the first N-type transistor TN1 further includes one of the NMOS transistor and the NPN BJT. The first P-type transistor TP1 further includes one of the PMOS transistor and the PNP BJT. The second N-type transistor TP2 further includes one of the NMOS transistor and the NPN BJT.

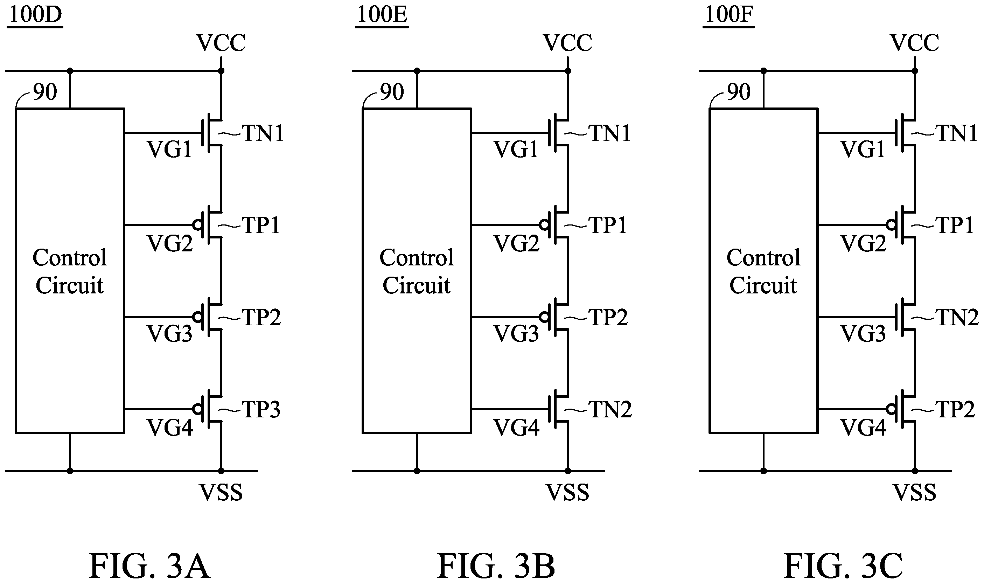

Figure 3A is a block diagram of a circuit protection device according to one embodiment of the present disclosure. As shown in Figure 3A, in one embodiment, a part of the circuit protection device 100D in Figure 3A may correspond to a part of the circuit protection device 100B in Figure 2B. What needs special explanation is that the circuit protection device 100D further includes a third P-type transistor TP3. The third P-type transistor TP3 includes a seventh terminal, a fourth gate terminal, and an eighth terminal. The seventh terminal is connected to the sixth terminal of the second P-type transistor TP2. The fourth gate terminal is connected to the control circuit 90.

For example, the seventh terminal of the third P-type transistor TP3 may receive (or couple to) the signal VCC, the fourth gate terminal of the third P-type transistor TP3 may receive the signal VG4, the eighth terminal of the third P-type transistor TP3 may receive (or couple to) the signal VSS, but the present disclosure is not limited thereto.

In one embodiment, the eighth terminal of the third P-type transistor TP3 is configured to receive the second voltage VSS. The second sub-terminal is configured to receive the second voltage VSS, the second sub-terminal is coupled to the eighth terminal of the third P-type transistor TP3. For example, the second sub-terminal of the control circuit 90 may connect to the eighth terminal of the third P-type transistor TP3, but the present disclosure is not limited thereto.

Figure 3B is a block diagram of a circuit protection device according to one embodiment of the present disclosure. As shown in Figure 3B, in one embodiment, a part of the circuit protection device 100E in Figure 3B may correspond to a part of the circuit protection device 100B in Figure 2B. What needs special explanation is that the circuit protection device 100E further includes a second N-type transistor TN2. The second N-type transistor TN2 includes the seventh terminal, the fourth gate terminal, and the eighth terminal. The seventh terminal is connected to the sixth terminal of the second P-type transistor TP2. The fourth gate terminal is connected to the control circuit 90.

For example, the seventh terminal of the second N-type transistor TN2 may receive the signal VCC, the fourth gate terminal of the second N-type transistor TN2 may receive the signal VG4, the eighth terminal of the second N-type transistor TN2 may receive the signal VSS, but the present disclosure is not limited thereto.

In one embodiment, the eighth terminal of the second N-type transistor TN2 is configured to receive the second voltage VSS. The second sub-terminal is configured to receive the second voltage VSS, the second sub-terminal is coupled to the eighth terminal of the second N-type transistor TN2. For example, the second sub-terminal of the control circuit 90 may connect to the eighth terminal of the second N-type transistor TN2, but the present disclosure is not limited thereto.

Figure 3C is a block diagram of a circuit protection device according to one embodiment of the present disclosure. As shown in Figure 3C, in one embodiment, a part of the circuit protection device 100F in Figure 3C may correspond to a part of the circuit protection device 100C in Figure 2C. What needs special explanation is that the circuit protection device 100F further includes the second P-type transistor TP2. The second P-type transistor includes the seventh terminal, the fourth gate terminal, and the eighth terminal. The seventh terminal is connected to the sixth terminal of the second N-type transistor TN2. The fourth gate terminal is connected to the control circuit 90.

For example, the seventh terminal of the second P-type transistor TP2 may receive the signal VCC, the fourth gate terminal of the second P-type transistor TP2 may receive the signal VG4, the eighth terminal of the second P-type transistor TP2 may receive the signal VSS, but the present disclosure is not limited thereto.

In one embodiment, the eighth terminal of the second P-type transistor TP2 is configured to receive the second voltage VSS. The second sub-terminal is configured to receive the second voltage VSS, the second sub-terminal is coupled to the eighth terminal of the second P-type transistor TP2. For example, the second sub-terminal of the control circuit 90 may connect to the eighth terminal of the second P-type transistor TP2, but the present disclosure is not limited thereto.

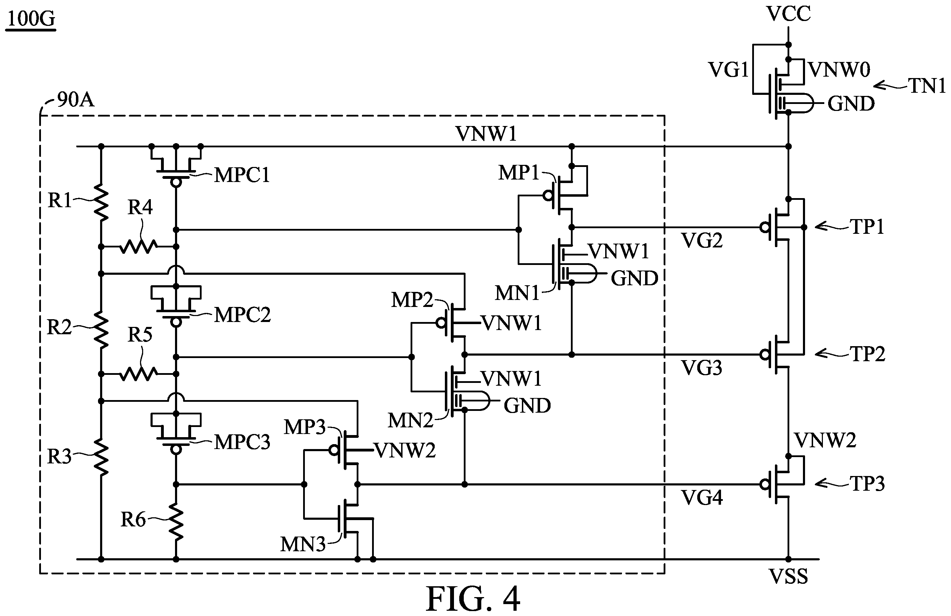

Figure 4 is a detailed circuit diagram of a circuit protection device according to one embodiment of the present disclosure. As shown in Figure 4, in one embodiment, a part of the circuit protection device 100G in Figure 4 may correspond to a part of the circuit protection device 100D in Figure 3A. What needs special explanation is that the first terminal of the first N-type transistor TN1 is connected to the first gate terminal of the first N-type transistor TN1. Compared with Figure 3A, the first terminal of the first N-type transistor TN1 may be not directly connected to the control circuit 90A in Figure 4, the second terminal of the first N-type transistor TN1 may be connected to the control circuit 90A in Figure 4, but the present disclosure is not limited thereto.

For example, the first terminal of the first N-type transistor TN1 may receive the first voltage VCC, the first gate terminal of the first N-type transistor TN1 may receive the first voltage VCC, but the present disclosure is not limited thereto.

In some embodiments, in details, the first terminal of the first N-type transistor TN1 may receive the voltage VCC, a first body terminal of the first N-type transistor TN1 is connected to the first terminal of the first N-type transistor TN1 and received to the voltage VNW0, a second body terminal is connected to the ground terminal, the second terminal of the first N-type transistor TN1 is connected to the control circuit 90A, and the first gate terminal is connected to the first terminal of the first N-type transistor TN1. The third terminal of the first P-type transistor TP1 is connected to the first N-type transistor TN1, a body terminal of the first P-type transistor TP1 is connected to the third terminal of the first P-type transistor TP1, the fourth terminal is connected to the second P-type transistor TP2, and the second gate terminal of the first P-type transistor TP1 is connected to the control circuit 90A, but the present disclosure is not limited thereto.

In this embodiment, the fifth terminal of the second P-type transistor TP2 is connected to the first P-type transistor TP1, a body terminal of the second P-type transistor TP2 is connected to the first P-type transistor TP1, the sixth terminal of the second P-type transistor TP2 is connected to the third P-type transistor TP3, the third gate terminal of the second P-type transistor TP2 is connected to the control circuit 90A. The seventh terminal of the third P-type transistor TP3 is connected to the second P-type transistor TP2, a body terminal of the third P-type transistor TP3 is connected to the seventh terminal of the third P-type transistor TP3, the eighth terminal of the third P-type transistor TP3 may receive the voltage VSS (such as the ground terminal ), the fourth gate terminal of the third P-type transistor TP3 is connected to the control circuit 90A, but the present disclosure is not limited thereto.

For example, the control circuit 90A may output the voltage (or signal) VG2 to the second gate terminal of the first P-type transistor TP1, the control circuit 90A may output the voltage (or signal) VG3 to the third gate terminal of the second P-type transistor TP2, and the control circuit 90A may output the voltage (or signal) VG4 to the fourth gate terminal of the third P-type transistor TP3, but the present disclosure is not limited thereto.

In some embodiments, the control circuit 90A in Figure 4 may correspond to the control circuit 90 in Figure 3A, but the present disclosure is not limited thereto. In details, a terminal of the resistor R1 is coupled to the P-type transistor MPC1, and other terminal of the resistor R1 is coupled to the resistor R2. A terminal of the resistor R2 is coupled to the resistor R4, and other terminal of the resistor R2 is coupled to the resistor R3. A terminal of the resistor R3 is coupled to the resistor R5, and other terminal of the resistor R3 is coupled to the resistor R6. A terminal of the resistor R4 is coupled to the resistor R1, and other terminal of the resistor R4 is coupled to the P-type transistor MPC1. A terminal of the resistor R5 is coupled to the resistor R2, and other terminal of the resistor R5 is coupled to the P-type transistor MPC2. A terminal of the resistor R6 is coupled to the P-type transistor MPC3, and other terminal of the resistor R6 is coupled to the N-type transistor MN3, but the present disclosure is not limited thereto.

In some embodiments, a terminal, other terminal, and a body terminal of the P-type transistor MPC1 are coupled to each other. The terminal of the P-type transistor MPC1 is coupled to the resistor R1, the other terminal of the P-type transistor MPC1 is coupled to the P-type transistor MP1, the gate terminal of the P-type transistor MPC1 is coupled to the P-type transistor MPC2. A terminal, other terminal, and a body terminal of the P-type transistor MPC2 are coupled to each other. The terminal of the P-type transistor MPC2 is coupled to the resistor R4, the other terminal of the P-type transistor MPC2 is coupled to the P-type transistor MP1, the gate terminal of the P-type transistor MPC2 is coupled to the P-type transistor MPC3. A terminal, other terminal, and a body terminal of the P-type transistor MPC3 are coupled to each other. The terminal of the P-type transistor MPC3 is coupled to the resistor R5, the other terminal of the P-type transistor MPC3 is coupled to the P-type transistor MP2, the gate terminal of the P-type transistor MPC3 is coupled to the P-type transistor MP3, but the present disclosure is not limited thereto.

In some embodiments, the P-type transistors MPC1, MPC2, MPC3 may be used as the capacitors, but the present disclosure is not limited thereto. In some embodiments, the P-type transistors MPC1, MPC2, MPC3 may be used as the diodes, but the present disclosure is not limited thereto.

In some embodiments, a terminal of the P-type transistor MP1 is coupled to the first N-type transistor TN1, a body terminal of the P-type transistor MP1 is coupled to the terminal of the P-type transistor MP1, other terminal of the P-type transistor MP1 is coupled to the first P-type transistor TP1, and a gate terminal of the P-type transistor MP1 is coupled to the resistor R4. A terminal of the N-type transistor MN1 is coupled to the P-type transistor MP1, a first body terminal of the N-type transistor MN1 may receive the voltage VNW1, and a second body terminal of the N-type transistor MN1 is coupled to the ground terminal. Other terminal of the N-type transistor MN1 is coupled to the second P-type transistor TP2, and the gate terminal of the N-type transistor MN1 is coupled to the P-type transistor MP1, but the present disclosure is not limited thereto.

In some embodiments, a terminal of the P-type transistor MP2 is coupled to the resistor R1, a body terminal of the P-type transistor MP2 may receive the voltage VNW1, other terminal of the P-type transistor MP2 is coupled to the second P-type transistor TP2, and a gate terminal of the P-type transistor MP2 is coupled to the resistor R5. A terminal of the N-type transistor MN2 is coupled to the P-type transistor MP2, a first body terminal of the N-type transistor MN2 may receive the voltage VNW1, and a second body terminal of the N-type transistor MN2 is coupled to the ground terminal. Other terminal of the N-type transistor MN2 is coupled to the third P-type transistor TP3, and the gate terminal of the N-type transistor MN2 is coupled to the P-type transistor MP2, but the present disclosure is not limited thereto.

In some embodiments, a terminal of the P-type transistor MP3 is coupled to the resistor R2, a body terminal of the P-type transistor MP3 may receive the voltage VNW2, other terminal of the P-type transistor MP3 is coupled to the third P-type transistor TP3, and a gate terminal of the P-type transistor MP3 is coupled to the resistor R6. A terminal of the N-type transistor MN3 is coupled to the P-type transistor MP3, a body terminal of the N-type transistor MN3 is coupled to the third P-type transistor TP3, other terminal of the N-type transistor MN3 is coupled to the body terminal of the N-type transistor MN3, and the gate terminal of the N-type transistor MN3 is coupled to the P-type transistor MP3, but the present disclosure is not limited thereto.

In some embodiments, the terminal of the resistor R1 may receive the voltage VNW1. The terminal, the other terminal, the body terminal of the P-type transistor MPC1 may receive the voltage VNW1. The terminal of the P-type transistor MP1 may receive the voltage VNW1. The other terminal of the resistor R3 may receive the voltage VSS, the other terminal of the resistor R6 may receive the voltage VSS, the other terminal of the N-type transistor MN3 may receive the voltage VSS, and the gate terminal of the N-type transistor MN3 may receive the voltage VSS, but the present disclosure is not limited thereto.

In some embodiments, the P-type transistor MP1 and the N-type transistor MN1 may form an inverter (or a comparator), the P-type transistor MP2 and the N-type transistor MN2 may form the inverter (or the comparator), and the P-type transistor MP3 and the N-type transistor MN3 may form the inverter (or the comparator), but the present disclosure is not limited thereto.

In some embodiments, the first N-type transistor TN1 may output a driving voltage into the P-type transistors MP1, MP2, MP3 and the N-type transistor MN1, MN2, MN3 according to the first voltage and the resistors R1~R6. In a first period, the P-type transistor MP3 and the N-type transistor MN3 outputs the signal VG4 to the fourth gate terminal of the third P-type transistor TP3 according to the driving voltage, and the third P-type transistor TP4 may be turned on according to the signal VG4.

In a second period, the P-type transistor MP2 and the N-type transistor MN2 outputs the signal VG3 to the third gate terminal of the second P-type transistor TP2 according to the driving voltage, and the second P-type transistor TP2 may be turned on according to the signal VG3. In a third period, the P-type transistor MP1 and the N-type transistor MN1 outputs the signal VG2 to the second gate terminal of the first P-type transistor TP1 according to the driving voltage, and the first P-type transistor TP1 may be turned on according to the signal VG2. The third period is later the second period, the second period is later the first period, but the present disclosure is not limited thereto.

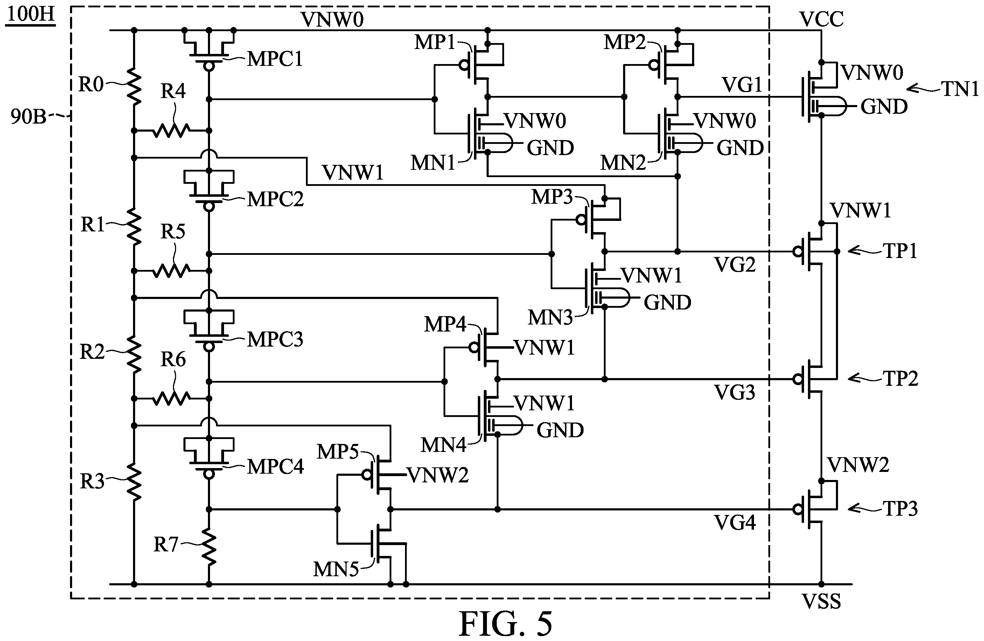

Figure 5 is a detailed circuit diagram of a circuit protection device according to one embodiment of the present disclosure. As shown in Figure 5, in one embodiment, a part of the circuit protection device 100H in Figure 5 may correspond to a part of the circuit protection device 100D in Figure 3A. What needs special explanation is that the first terminal of the first N-type transistor TN1 is connected to the control circuit 90B.

For example, the first terminal of the first N-type transistor TN1 may receive the first voltage VCC, the gate terminal of the first N-type transistor TN1 may receive the voltage VG1 from the control circuit 90B, and the control circuit 90B may receive the first voltage VCC, but the present disclosure is not limited thereto.

In some embodiments, in details, the first terminal of the first N-type transistor TN1 may receive the voltage VCC, a first body terminal of the first N-type transistor TN1 is connected to the first terminal of the first N-type transistor TN1 and received to the voltage VNW0, a second body terminal is connected to the ground terminal, the second terminal of the first N-type transistor TN1 is connected to the first P-type transistor TP1. The third terminal of the first P-type transistor TP1 is connected to the first N-type transistor TN1, a body terminal of the first P-type transistor TP1 is connected to the third terminal of the first P-type transistor TP1, the fourth terminal is connected to the second P-type transistor TP2, and the second gate terminal of the first P-type transistor TP1 is connected to the control circuit 90B, but the present disclosure is not limited thereto.

In this embodiment, the fifth terminal of the second P-type transistor TP2 is connected to the first P-type transistor TP1, a body terminal of the second P-type transistor TP2 is connected to the first P-type transistor TP1, the sixth terminal of the second P-type transistor TP2 is connected to the third P-type transistor TP3, and the third gate terminal of the second P-type transistor TP2 is connected to the control circuit 90B. The seventh terminal of the third P-type transistor TP3 is connected to the second P-type transistor TP2, a body terminal of the third P-type transistor TP3 is connected to the seventh terminal of the third P-type transistor TP3, the eighth terminal of the third P-type transistor TP3 may receive the voltage VSS (such as the voltage VSS comes from the ground terminal), and the fourth gate terminal of the third P-type transistor TP3 is connected to the control circuit 90B, but the present disclosure is not limited thereto.

For example, the control circuit 90B may output the voltage (or signal) VG1 to the first gate terminal of the first N-type transistor TN1, the control circuit 90B may output the voltage (or signal) VG2 to the second gate terminal of the first P-type transistor TP1, the control circuit 90B may output the voltage (or signal) VG3 to the third gate terminal of the second P-type transistor TP2, and the control circuit 90B may output the voltage (or signal) VG4 to the fourth gate terminal of the third P-type transistor TP3, but the present disclosure is not limited thereto.

In some embodiments, an operation, a hardware connection, and a design logic of the control circuit 90B in Figure 5 may be similar to an operation, a hardware connection, and a design logic of the control circuit 90A in Figure 4, the control circuit 90B in Figure 5 may get more or fewer resistors and transistors to meet design needs, in order to concisely describe the contents of the present disclosure, they are not repeated herein.

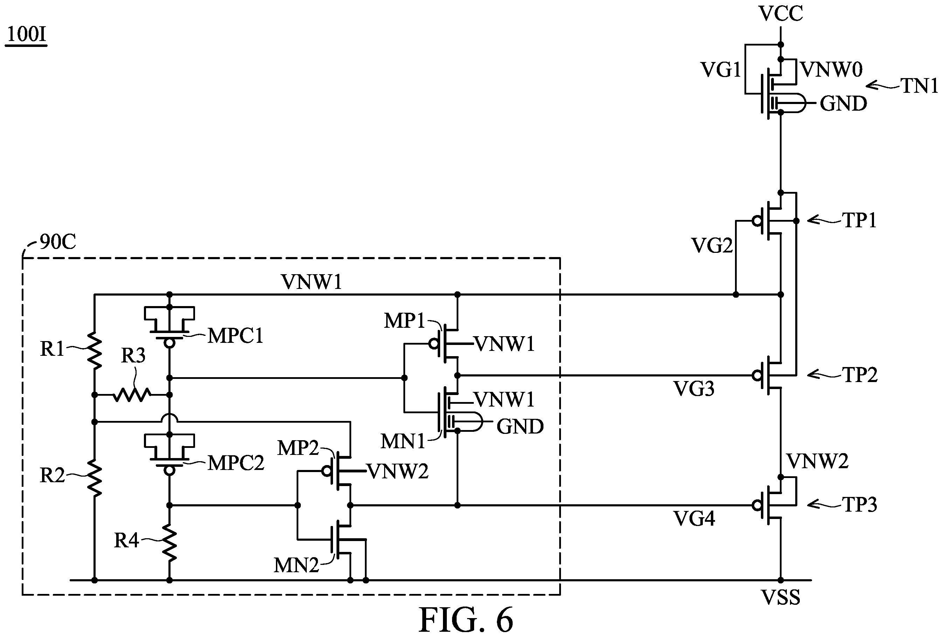

Figure 6 is a detailed circuit diagram of a circuit protection device according to one embodiment of the present disclosure. As shown in Figure 6, in one embodiment, a part of the circuit protection device 100I in Figure 6 may correspond to the part of the circuit protection device 100D in Figure 3A.

Furthermore, operations and connections of the first N-type transistor TN1, the first P-type transistor TP1, the second P-type transistor TP2, and the third P-type transistor TP3 in Figure 6 may be similar to operations and connections of the first N-type transistor TN1, the first P-type transistor TP1, the second P-type transistor TP2, and the third P-type transistor TP3 in Figure 4, in order to concisely describe the contents of the present disclosure, they are not repeated herein. What needs special explanation is that the second gate terminal of the first P-type transistor TP1 is connected to the fourth terminal of the first P-type transistor TP1.

In some embodiments, an operation, a hardware connection and a design logic of the control circuit 90C in Figure 6 may be similar to the operation, the hardware connection, and the design logic of the control circuit 90A in Figure 4, the control circuit 90C in Figure 6 may get more or fewer resistors and transistors to meet design needs, in order to concisely describe the contents of the present disclosure, they are not repeated herein.

For example, the circuit 90C may output the voltage (or signal) VG3 to the third gate terminal of the second P-type transistor TP2, the circuit 90C may output the voltage (or signal) VG4 to the fourth gate terminal of the third P-type transistor TP3, but the present disclosure is not limited thereto.

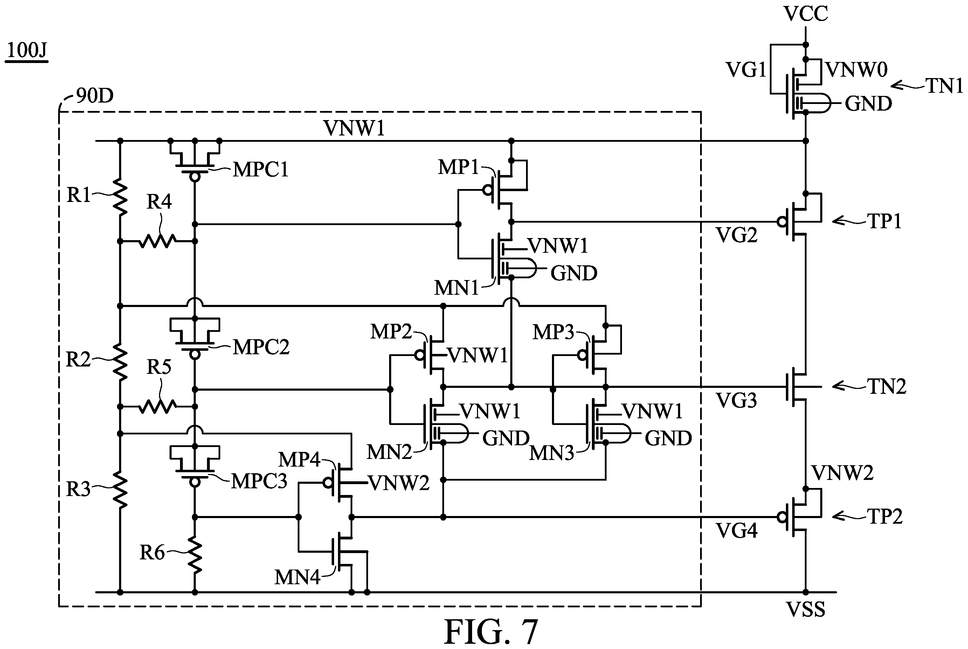

Figure 7 is a detailed circuit diagram of a circuit protection device according to one embodiment of the present disclosure. As shown in Figure 7, in one embodiment, a part of the circuit protection device 100J in Figure 7 may correspond to a part of the circuit protection device 100F in Figure 3C.

Furthermore, connections of the first N-type transistor TN1, the first P-type transistor TP1, the second N-type transistor TN2, and the second P-type transistor TP2 in Figure 7 may be similar to operations and connections of the first N-type transistor TN1, the first P-type transistor TP1, the second P-type transistor TP2, and the third P-type transistor TP3 in Figure 4, in order to concisely describe the contents of the present disclosure, they are not repeated herein. What needs special explanation is that there replace the second P-type transistor TP2 (in Figure 4) with the second N-type transistor TN2 (in Figure 6).

In some embodiments, an operation, a hardware connection and a design logic of the control circuit 90D in Figure 7 may be similar to the operation, the hardware connection, and the design logic of the control circuit 90A in Figure 4, the control circuit 90D in Figure 7 may get more or fewer resistors and transistors to meet design needs, in order to concisely describe the contents of the present disclosure, they are not repeated herein.

For example, the circuit 90D may output the voltage (or signal) VG2 to the second gate terminal of the first P-type transistor TP 1, the circuit 90D may output the voltage (or signal) VG3 to the third gate terminal of the second N-type transistor TN2, and the circuit 90D may output the voltage (or signal) VG4 to the fourth gate terminal of the second P-type transistor TP2, but the present disclosure is not limited thereto.

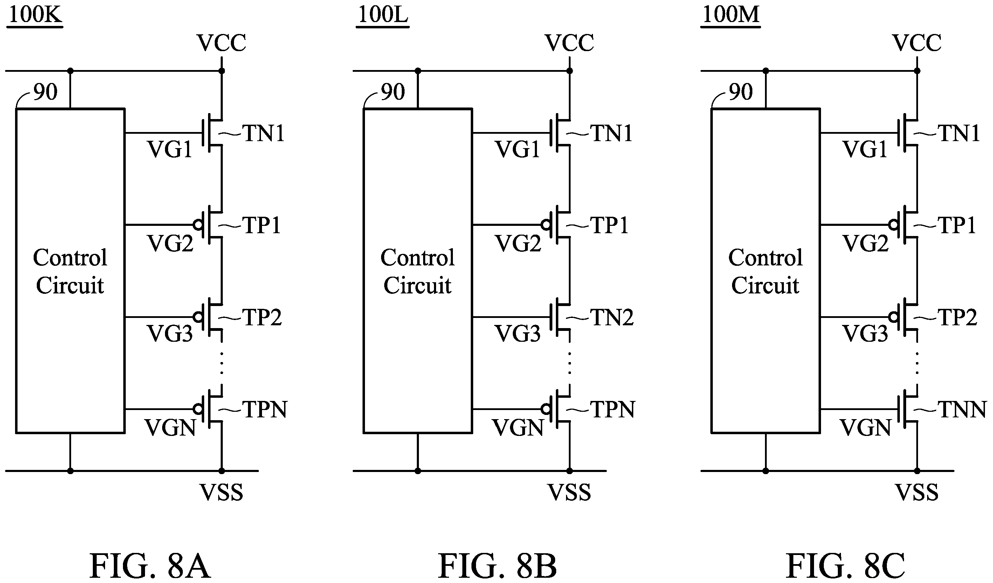

Figure 8A is a block diagram of a circuit protection device according to one embodiment of the present disclosure. As shown in Figure 8A, in one embodiment, a part of the circuit protection device 100K in Figure 8A may correspond to a part of the circuit protection device 100D in Figure 3A. What needs special explanation is that there have a plurality of P-type transistors (such as the P-type transistors TP3 to TPN), the plurality of P-type transistors are coupled to the second P-type transistor TP2 in series.

For example, an operation, a hardware connection and a design logic of the circuit protection device 100K in Figure 8A may be similar to the operation, the hardware connection, and the design logic of the circuit protection device 100D in Figure 3A, the plurality of P-type transistors may get more or fewer transistors to meet design needs, in order to concisely describe the contents of the present disclosure, they are not repeated herein.

Figure 8B is a block diagram of a circuit protection device according to one embodiment of the present disclosure. As shown in Figure 8B, in one embodiment, a part of the circuit protection device 100L in Figure 8B may correspond to a part of the circuit protection device 100F in Figure 3C. What needs special explanation is that there have a plurality of P-type transistors and a plurality of N-type transistors, the plurality of P-type transistors and the plurality of N-type transistors are arranged in a staggered manner, and the plurality of P-type transistors and the plurality of N-type transistors are coupled to the second N-type transistor TN2 in series.

For example, an operation, a hardware connection and a design logic of the circuit protection device 100L in Figure 8B may be similar to the operation, the hardware connection, and the design logic of the circuit protection device 100F in Figure 3C, the plurality of P-type transistors and the plurality of N-type transistors may get more or fewer transistors to meet design needs, in order to concisely describe the contents of the present disclosure, they are not repeated herein.

Figure 8C is a block diagram of a circuit protection device according to one embodiment of the present disclosure. As shown in Figure 8C, in one embodiment, a part of the circuit protection device 100M in Figure 8C may correspond to a part of the circuit protection device 100E in Figure 3B. What needs special explanation is that there have a plurality of N-type transistors (such as the N-type transistors TN2 to TNN), the plurality of N-type transistors are coupled to the second P-type transistor TP2 in series.

For example, an operation, a hardware connection and a design logic of the circuit protection device 100M in Figure 8C may be similar to the operation, the hardware connection, and the design logic of the circuit protection device 100E in Figure 3B, the plurality of N-type transistors may get more or fewer transistors to meet design needs, in order to concisely describe the contents of the present disclosure, they are not repeated herein.

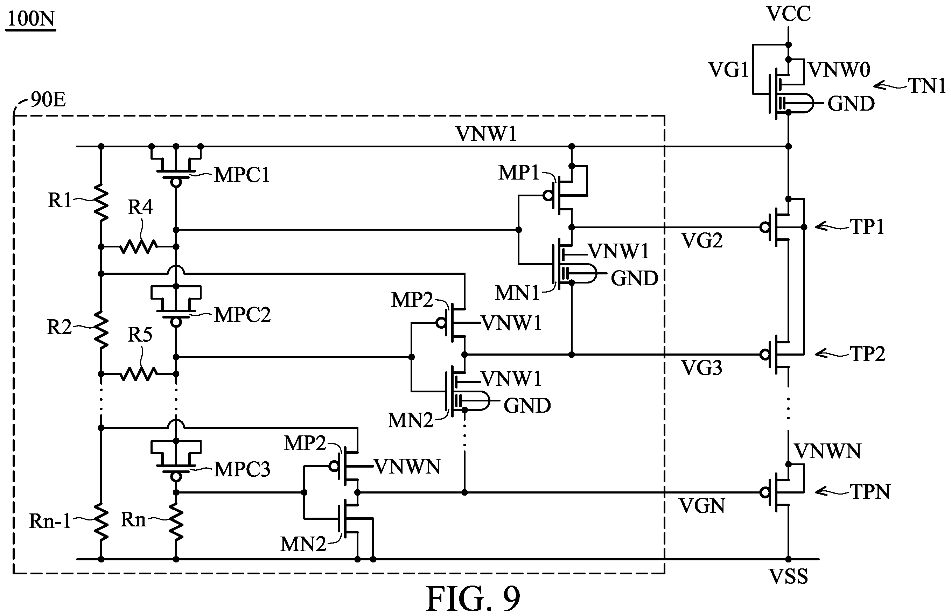

Figure 9 is a detailed circuit diagram of a circuit protection device according to one embodiment of the present disclosure. As shown in Figure 9, in one embodiment, a part of the circuit protection device 100N in Figure 9 may correspond to a part of the circuit protection device 100K in Figure 8A. Furthermore, in details, an operation, a hardware connection and a design logic of the circuit protection device 100N in Figure 9 may be similar to the operation, the hardware connection, and the design logic of the circuit protection device 100G in Figure 4, in order to concisely describe the contents of the present disclosure, they are not repeated herein.

In some embodiments, an operation, a hardware connection and a design logic of the control circuit 90E in Figure 9 may be similar to the operation, the hardware connection, and the design logic of the control circuit 90A in Figure 4, the control circuit 90E in Figure 9 may get more or fewer resistors and transistors to meet design needs, in order to concisely describe the contents of the present disclosure, they are not repeated herein.

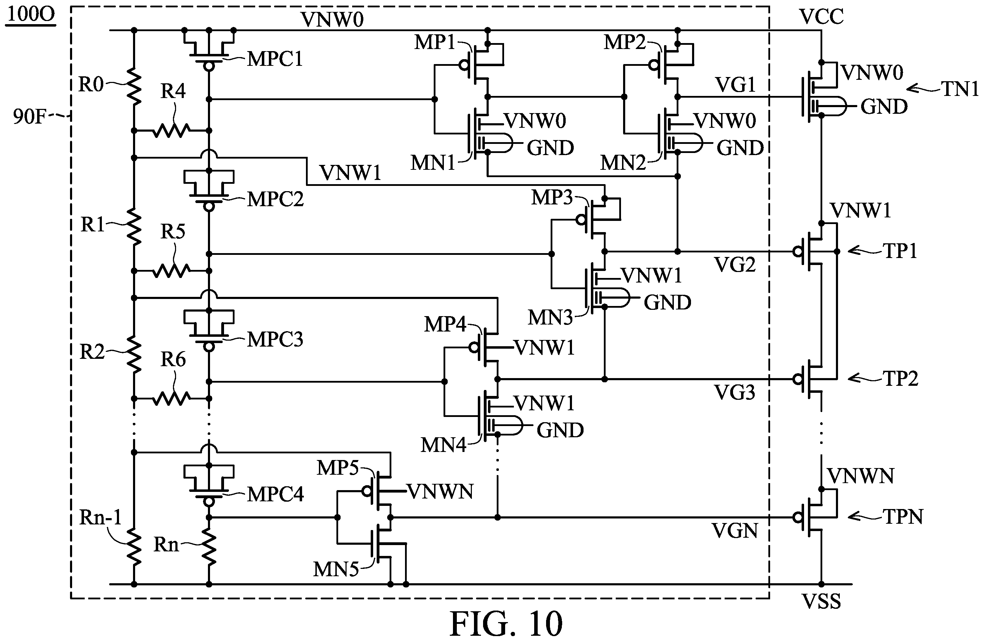

Figure 10 is a detailed circuit diagram of a circuit protection device according to one embodiment of the present disclosure. As shown in Figure 10, in one embodiment, a part of the circuit protection device 100O in Figure 10 may correspond to a part of the circuit protection device 100K in Figure 8A. Furthermore, in details, an operation, a hardware connection and a design logic of the circuit protection device 100O in Figure 10 may be similar to the operation, the hardware connection, and the design logic of the circuit protection device 100H in Figure 5, in order to concisely describe the contents of the present disclosure, they are not repeated herein.

In some embodiments, an operation, a hardware connection and a design logic of the control circuit 90F in Figure 10 may be similar to the operation, the hardware connection, and the design logic of the control circuit 90B in Figure 5, the control circuit 90F in Figure 10 may get more or fewer resistors and transistors to meet design needs, in order to concisely describe the contents of the present disclosure, they are not repeated herein.

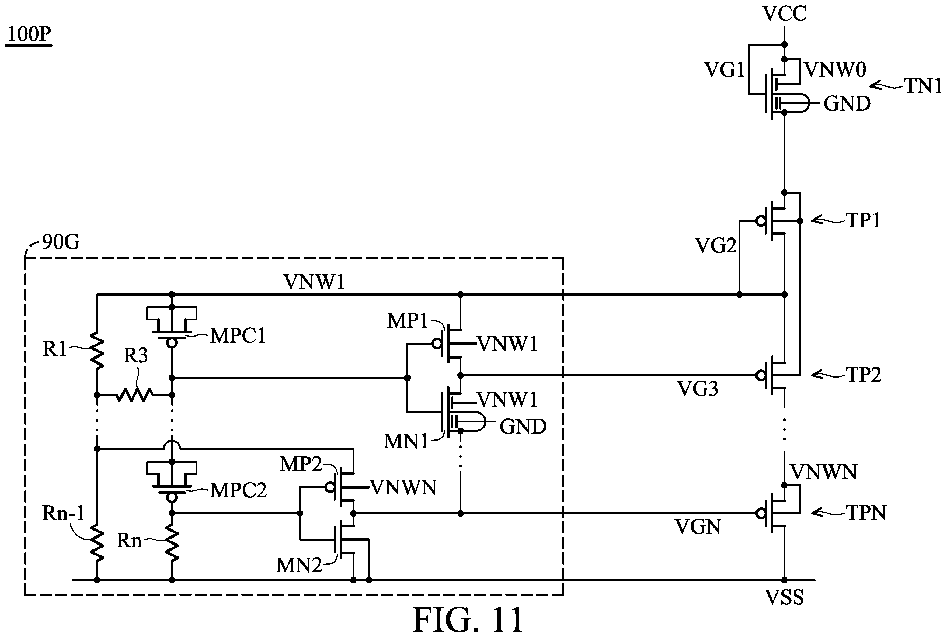

Figure 11 is a detailed circuit diagram of a circuit protection device according to one embodiment of the present disclosure. As shown in Figure 11, in one embodiment, a part of the circuit protection device 100P in Figure 11 may correspond to a part of the circuit protection device 100K in Figure 8A. Furthermore, in details, an operation, a hardware connection and a design logic of the circuit protection device 100P in Figure 11 may be similar to the operation, the hardware connection, and the design logic of the circuit protection device 100I in Figure 6, in order to concisely describe the contents of the present disclosure, they are not repeated herein.

In some embodiments, an operation, a hardware connection and a design logic of the control circuit 90G in Figure 11 may be similar to the operation, the hardware connection, and the design logic of the control circuit 90C in Figure 6, the control circuit 90G in Figure 11 may get more or fewer resistors and transistors to meet design needs, in order to concisely describe the contents of the present disclosure, they are not repeated herein.

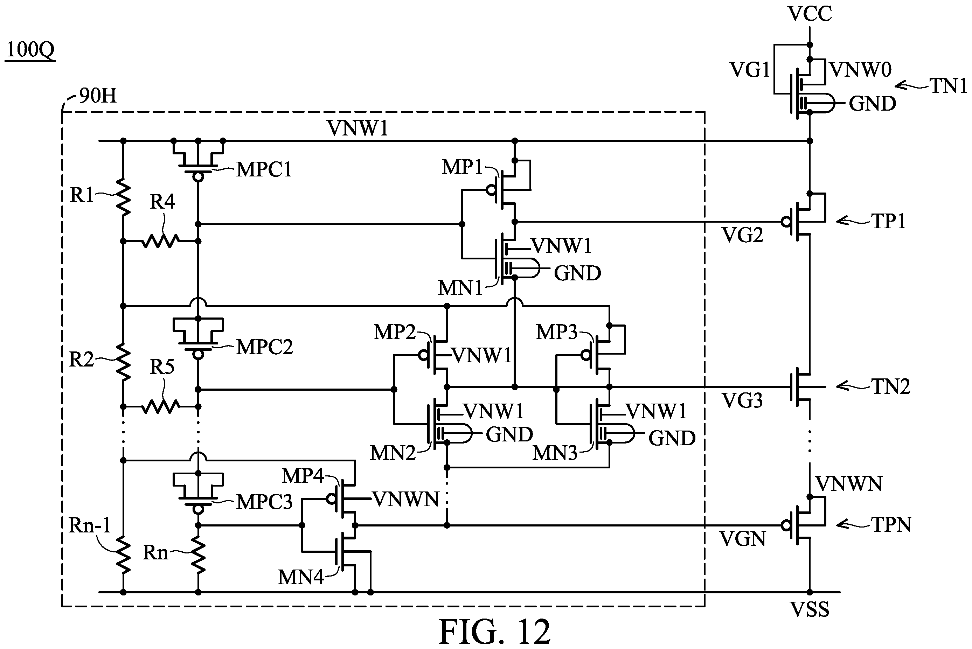

Figure 12 is a detailed circuit diagram of a circuit protection device according to one embodiment of the present disclosure. As shown in Figure 12, in one embodiment, a part of the circuit protection device 100Q in Figure 12 may correspond to a part of the circuit protection device 100L in Figure 8B. Furthermore, in details, an operation, a hardware connection and a design logic of the circuit protection device 100Q in Figure 12 may be similar to the operation, the hardware connection, and the design logic of the circuit protection device 100J in Figure 7, in order to concisely describe the contents of the present disclosure, they are not repeated herein.

In some embodiments, an operation, a hardware connection and a design logic of the control circuit 90H in Figure 12 may be similar to the operation, the hardware connection, and the design logic of the control circuit 90D in Figure 7, the control circuit 90 H in Figure 12 may get more or fewer resistors and transistors to meet design needs, in order to concisely describe the contents of the present disclosure, they are not repeated herein.

In some embodiments, one of the plurality of N-type transistors of the present disclosure may be an NMOS transistor or an NPN BJT, but the present disclosure is not limited thereto. In some embodiments, one of the plurality of P-type transistors of the present disclosure may be the PMOS transistor or the PNP BJT, but the present disclosure is not limited thereto.

Therefore, according to the technical content of the present disclosure, the circuit protection device shown in the embodiment of the present disclosure can achieve the effect of using one VDD replacing multiple VDDs by using the stacked device electrostatic discharge clamp.

Furthermore, the stacked device electrostatic discharge clamp (such as the circuit protection device of the present disclosure) use several devices (such as the N-type transistor and/or the P-type transistor of the present disclosure) to tolerance high VDD for reliability requirement.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A circuit protection device, comprising:
a control circuit;
a first N-type transistor, comprising:
a first terminal, configured to receive a first voltage;
a first gate terminal, coupled to the control circuit;
a second terminal; and
a first P-type transistor, comprising:
a third terminal, connected to the second terminal of the first N-type transistor;
a second gate terminal, connected to the control circuit; and
a fourth terminal, configured to receive a second voltage;
wherein a first voltage value of the first voltage is greater than a second voltage value of the second voltage.

2. The circuit protection device as claimed in claim 1, wherein
the circuit protection device further comprises a stacked device electrostatic discharge clamp;
wherein the control circuit further comprises a first sub-terminal and a second sub-terminal;
wherein the first sub-terminal is configured to receive the first voltage, and the first sub-terminal of the control circuit is coupled to the first terminal of the first N-type transistor.

3. The circuit protection device as claimed in claim 2, wherein
the second sub-terminal is configured to receive the second voltage, and the second sub-terminal is coupled to the fourth terminal of the first P-type transistor.

4. The circuit protection device as claimed in claim 2, further comprising:
a second P-type transistor, comprising:
a fifth terminal, connected to the fourth terminal of the first P-type transistor;
a third gate terminal, connected to the control circuit; and
a sixth terminal.

5. The circuit protection device as claimed in claim 4, wherein
the sixth terminal of the second P-type transistor is configured to receive the second voltage;
wherein the second sub-terminal is configured to receive the second voltage, the second sub-terminal is coupled to the sixth terminal of the second P-type transistor.

6. The circuit protection device as claimed in claim 4, further comprising:
a third P-type transistor, comprising:
a seventh terminal, connected to the sixth terminal of the second P-type transistor;
a fourth gate terminal, connected to the control circuit; and
an eighth terminal;
wherein the eighth terminal of the third P-type transistor is configured to receive the second voltage;
wherein the second sub-terminal is configured to receive the second voltage, the second sub-terminal is coupled to the eighth terminal of the third P-type transistor.

7. The circuit protection device as claimed in claim 4, further comprising:
a second N-type transistor, comprising:
a seventh terminal, connected to the sixth terminal of the second P-type transistor;
a fourth gate terminal, connected to the control circuit; and
an eighth terminal;
wherein the eighth terminal of the second N-type transistor is configured to receive the second voltage;
wherein the second sub-terminal is configured to receive the second voltage, and the second sub-terminal is coupled to the eighth terminal of the second N-type transistor.

8. The circuit protection device as claimed in claim 2, further comprising:
a second N-type transistor, comprising:
a fifth terminal, connected to the fourth terminal of the first P-type transistor;
a third gate terminal, connected to the control circuit; and
a sixth terminal.

9. The circuit protection device as claimed in claim 8, wherein
the sixth terminal of the second N-type transistor is configured to receive the second voltage;
wherein the second sub-terminal is configured to receive the second voltage, the second sub-terminal is coupled to the sixth terminal of the second N-type transistor.

10. The circuit protection device as claimed in claim 8, further comprising:
a second P-type transistor, comprising:
a seventh terminal, connected to the sixth terminal of the second N-type transistor;
a fourth gate terminal, connected to the control circuit; and
an eighth terminal;
wherein the eighth terminal of the second P-type transistor is configured to receive the second voltage;
wherein the second sub-terminal is configured to receive the second voltage, and the second sub-terminal is coupled to the eighth terminal of the second P-type transistor.

11. The circuit protection device as claimed in claim 6, wherein
the first terminal of the first N-type transistor is connected to the first gate terminal of the first N-type transistor.

12. The circuit protection device as claimed in claim 11, wherein
a first body terminal of the first N-type transistor is connected to the first terminal of the first N-type transistor, and a second body terminal is connected to a ground terminal,
wherein a third body terminal of the first P-type transistor is connected to the third terminal of the first P-type transistor,
wherein a fourth body terminal of the second P-type transistor is connected to the first P-type transistor,
wherein a fifth body terminal of the third P-type transistor is connected to the seventh terminal of the third P-type transistor.

13. The circuit protection device as claimed in claim 6, wherein
the first terminal of the first N-type transistor is connected to the control circuit.

14. The circuit protection device as claimed in claim 6, wherein
the second gate terminal of the first P-type transistor is connected to the fourth terminal of the first P-type transistor.

15. The circuit protection device as claimed in claim 1, wherein
the first N-type transistor further comprises one of an N-channel Metal-Oxide-Semiconductor (NMOS) transistor and an NPN bipolar junction transistor (BJT);
wherein the first P-type transistor further comprises one of a P-channel Metal-Oxide-Semiconductor (PMOS) transistor and a PNP bipolar junction transistor.
